# EUROPÄISCHE PATENTSCHRIFT

(11) **EP 2 878 016 B1**
(45) Veröffentlichungstag und Bekanntmachung des Hinweises auf die Patenterteilung: **13.06.2018**
(21) Anmeldenummer: 13745580.4
(22) Anmeldetag: 23.07.2013
(51) Int. Cl.: H01L 41/053, H01L 41/083, H01L 41/12

(54) **STELLANTRIEB MIT KÜHLUNG EINES EINGEHAUSTEN FESTKÖRPERAKTORS**
ACTUATION MECHANISM WITH COOLING OF A HOUSED SOLID-STATE ACTUATOR
MÉCANISME DE COMMANDE AVEC REFROIDISSEMENT D'UN ACTIONNEUR À L'ÉTAT SOLIDE ENCAPSULÉ

(30) Priorität: 27.07.2012 DE 102012014892
(43) Veröffentlichungstag der Anmeldung: 03.06.2015
(73) Patentinhaber: Fraunhofer Gesellschaft zur Förderung der angewandten Forschung e.V., 80686 München (DE)
(72) Erfinder: MELZ, Tobias, 64285 Darmstadt (DE); MATTHIAS, Michael, 64331 Weiterstadt (DE); HANSELKA, Holger, 64297 Darmstadt (DE)
(74) Vertreter: Rösler, Uwe
(86) Internationale Anmeldenummer: PCT/EP2013/002192
(87) Internationale Veröffentlichungsnummer: WO 2014/015979

(56) Entgegenhaltungen:
- EP-A2- 1 705 722
- WO-A2-98/52274
- JP-A- S6 019 968
- JP-A- H07 131 085

## Beschreibung

### Technisches Gebiet

Die Erfindung bezieht sich auf einen Stellantrieb zum uniaxialen, bidirektionalen Auslenken eines Stellgliedes, das mittel- oder unmittelbar durch einen Festkörperaktor betätigbar ist, der wenigstens ein sich an einer ersten Stirnseite in einem Gehäuse abstützendes Festkörperaktorende aufweist, das bei Änderung einer je nach Aktortypus am Festkörperaktor anlegbaren elektrischen Spannung oder eines am Festkörperaktor wirkenden Magnetfeldes zumindest eine Längenänderung in einer dem Festkörperaktor zuordenbaren Längserstreckung erfährt, die mittels einer der ersten Stirnseite in Längserstreckung des Festkörperaktors gegenüberliegenden zweiten Stirnseite mittel- oder unmittelbar auf das Stellglied zu dessen Verstellung übertragbar ist. Ferner wird ein Verfahren zum Entwärmen eines in einem Stellantrieb mit einem Stellmittel eingehausten Festkörperaktors erläutert.

### Stand der Technik

Stellantriebe, in denen Festkörperaktoren, vorzugsweise auf Basis von piezoelektrischen oder magnetostriktiven Materialien, zur Stellwegauslenkung integriert sind, unterliegen insbesondere im dynamischen Leistungsbetrieb aufgrund der Wandlermaterial inhärenten Hysterese sowie der systembedingten Einhausung des Festkörperaktors einer Erwärmung. Werden keine zur Entwärmung des Festkörperaktors dienenden Maßnahmen getroffen, so besteht zum einen die Gefahr des Verlustes der geometrischen Maßhaltigkeit des Festkörperaktors aufgrund thermischer Materialausdehnung, zum anderen können bei Überschreiten der materialspezifischen Curie-Temperatur die dem Wandlermaterial zueigenen energiewandelnden Eigenschaften verloren gehen. Überdies führt eine betriebsbedingte Eigenerwärmung des Festkörperaktors zumeist zu einer elektrischen Leistungsbedarfssteigerung, wodurch die Ansteuerung des Festkörperaktors deutlich negativ beeinflusst wird.

Zur Wärmeabführung wird typischerweise ein elastomerartiges Medium, zumeist mit zusätzlich wärmeableitenden Partikeln, um den Festkörperaktor innerhalb des Stellantriebgehäuses vergossen. Als Entwärmungsprinzip dient somit die Wärmeableitung von der Festkörperoberfläche über das elastomere Medium an das umgebende Gehäuse.

Ein typischer Anwendungsfall eines bspw. mit einem piezoelektrischen Aktor ausgerüsteten Stellantriebs stellt die Betätigung von Steuerventilen oder Einspritzventilen in Kraftfahrzeugen dar. Ein derartiger piezoelektrischer Aktor ist in der DE 199 14 411 A1 beschrieben und besteht aus einem vielschichtigen Laminat aus aufeinander geschichteten Lagen piezoelektrischen Materials mit dazwischen befindlichen metallischen bzw. elektrisch leitenden, als Elektroden dienenden Schichten. Der auch als Stapelaktor bezeichnete Aktorkörper ist innerhalb eines hohlzylinderartig ausgeformten Stellweggehäuses integriert und stützt sich einseitig auf einer innerhalb des Gehäuses fixierten Grundplatte ab. Das gegenüberliegende Stapelaktorende kontaktiert einen Ventilstößel, den es in Stapelaktorlängsrichtung auszulenken gilt. Ferner lastet innerhalb des Stellantriebgehäuses auf das gegenüberliegende Ende des Stapelaktors eine, eine Rückstellkraft generierende Feder. Zu Zwecken der Entwärmung des Stapelaktors ist eine elektrisch isolierende Elastomerhülle vorgesehen, die eng an der Innenwand des hohlzylinderartig ausgebildeten Stellantriebgehäuses sowie an dem Stapelaktor anliegt.

Einen vergleichbaren Kraftstoffinjektor mit einem Piezoelement offenbart die Druckschrift DE 11 2009 001 571 T5, bei dem ein Piezoelement innerhalb eines Injektorgehäuses eingebracht ist und mit diesem einen Hohlraum begrenzt, der zumindest teilweise mit einem thermisch leitfähigen Material zur Übertragung von Wärme von dem Piezoelement auf das Gehäuse gefüllt ist.

Aus der DE 103 28 373 A1 ist ein piezoelektrisches Bauteil mit einer integrierten Temperiervorrichtung zu entnehmen, die sich aus einem aus elastomeren Polymer bestehenden Verbundmaterial zusammensetzt und als Trägermatrix für Kohlenstofffasern dient, die vorzugsweise in Form von Kohlenstoff-Nanoröhrchen für eine besonders effektive Entwärmung des piezoelektrischen Bauteils dienen.

Der DE 10 2004 050 880 B4 ist ein Kraftstoffinjektor mit einem eingehausten Aktor zu entnehmen, wobei für eine verbesserte Wärmeabführung die dem Aktor abgewandte Oberfläche der Einhausung über Oberflächen vergrößernde Mirkostrukturen verfügt.

Aus den Druckschriften DE 10 2009 026 533 A1 sowie DE 198 26 339 A1 sind vergleichbare, jeweils über piezoelektrische Aktoren verfügende Stellantriebe zu entnehmen, die zu Zwecken einer aktiven Entwärmung des Piezoaktors elektrisch aktivierbare Kühlelemente in Form von Peltierelementen vorsehen.

Der Druckschrift JP 07131085 A ist ein piezoelektrischer Aktor in Form eines aus einer Vielzahl einzelner piezoelektrischer Lochscheiben zusammengesetzten Aktorstapels zu entnehmen, in dessen inneren Hohlkanal zu Kühlzwecken eine doppelrohrartige Kühlstruktur eingebracht ist.

Der Druckschrift JP 7094797 A ist gleichfalls ein aus einer Vielzahl einzelner piezoelektrischer Lochscheiben zusammengesetzter Piezoaktorstapel zu entnehmen, der über einen innenliegenden Hohlraum verfügt sowie mit einem den Piezoaktorstapel umfassenden Gehäuse einen Zwischenraum einschließt. Zu Kühlzwecken zirkuliert ein Kühlmittel in einem geschlossenen Kühlkreislauf durch den innenliegenden Hohlraum sowie den radial außen liegenden Zwischenraum des Aktors. Die Zirkulation des Kühlmittels wird durch Ventile gesteuert, die abwechselnd geöffnet und geschlossen werden. Weitere Anordnungen zur Kühlung eines in einem Gehäuse angeordneten Aktors basierend auf einem piezoelektrischen Aktorstapel oder magnetostriktiven Element mit einem axial durchströmten inneren Kühlkanal sind etwa aus den Schriften JP S60-19968 A oder WO 98/52274 A2 bekannt.

### Darstellung der Erfindung

Der Erfindung liegt die Aufgabe zugrunde, einen Stellantrieb zum uniaxial bidirektionalen Auslenken eines Stellgliedes, das mittel- oder unmittelbar durch einen Festkörperaktor betätigbar ist, der wenigstens ein sich mit einer ersten Stirnseite in einem Gehäuse abstützendes Festkörperaktorende aufweist, das bei Änderung einer am Festkörperaktor anlegbaren elektrischen Spannung oder eines am Festkörperaktor wirkenden Magnetfeldes zumindest eine Längenänderung in einer dem Festkörperaktor zuordenbaren Längserstreckung erfährt, die mittels einer der ersten Stirnseite in Längserstreckung des Festkörperaktors gegenüberliegenden zweiten Stirnseite mittel- oder unmittelbar auf das Stellglied zu dessen Verstellung übertragbar ist, derart weiterzubilden, dass einer betriebsbedingten Erwärmung des Festkörperaktors, insbesondere in einem dynamischen Leistungsbetrieb, durch eine effektivere Wärmeableitung entgegengetreten wird, als es mit den bisher bekannten Kühlmaßnahmen der Fall ist. Insbesondere sollen die für die Kühlung des Festkörperaktors zu treffenden Maßnahmen das Einsatzspektrum des Stellantriebes weder behindern noch beschränken und darüber hinaus mit möglichst einfachen, kostengünstigen konstruktiven Vorkehrungen darstellbar sein.

Die Lösung der der Erfindung zugrunde liegenden Aufgabe ist im Anspruch 1 angegeben. Den Erfindungsgedanken vorteilhaft weiterbildende Merkmale sind Gegenstand der Unteransprüche sowie der weiteren Beschreibung insbesondere unter Bezugnahme auf die Ausführungsbeispiele zu entnehmen.

Lösungsgemäß ist ein Stellantrieb gemäß den Merkmalen des Oberbegriffes des Anspruches 1 derart ausgebildet, dass das Gehäuse den Festkörperaktor zumindest abschnittsweise umschließt und mit dem Festkörperaktor wenigstens einen Zwischenraum fluiddicht begrenzt. Der Festkörperaktor weist zudem einen, den Festkörperaktor zumindest bereichsweise, vorzugsweise vollständig durchsetzenden Hohlkanal auf, dessen ein Hohlkanalende mit einer das Gehäuse durchsetzenden ersten Hohlleitung verbunden ist. Das andere Hohlkanalende des zumindest teilweise durch den Festkörperaktor hindurchragenden Hohlkanals mündet mittel-oder unmittelbar in den wenigstens einen Zwischenraum, den der Festkörperaktor mit dem Gehäuse fluiddicht begrenzt. Zudem ist der wenigstens eine Zwischenraum fluiddicht mit einer das Gehäuse durchsetzenden zweiten Hohlleitung verbunden.

Das lösungsgemäß vorgeschlagene Kühlkonzept für eine effektive Entwärmung des sich betriebsbedingt erwärmenden Festkörperaktors nutzt die thermische Ankopplung eines gasförmigen oder flüssigen Kühlmittels an die unmittelbare Oberfläche des innerhalb des Stellantriebes eingehausten Festkörperaktors. Um für eine effektive Kühlung zu sorgen, sieht der wenigstens eine Festkörperaktor wenigstens einen liegenden Hohlkanal vor, durch den über eine geeignete Zuleitung das Kühlmittel zugeleitet wird. Das Kühlmittel durchströmt somit zunächst den innen liegenden Hohlkanal des Festkörperaktors, wodurch dieser von innen einen wirksamen Wärmeentzug erfährt. Nach Durchtritt des Kühlmittels durch den Hohlkanal wird das Kühlmittel in geeigneter Weise umgeleitet, so dass es in umgekehrter Überströmungsrichtung verglichen zur längs des innen liegenden Hohlkanals orientierten Durchströmungsrichtung mit der außen liegenden Festkörperaktoroberfläche in thermischen Kontakt tritt. Hierbei erfolgt ein von außen auf den Festkörperaktor einwirkender Wärmeentzug. Nachdem das Kühlmittel vorzugsweise die gesamte Außenoberfläche des Festkörperaktors überströmt hat, wird das Kühlmittel von diesem und ebenso aus dem Stellantrieb über eine entsprechende Ableitung abgeführt. Selbstverständlich ist es möglich den Stellantrieb mit einer umgekehrten Durchströmungsrichtung mit dem Kühlmittel zu beaufschlagen, d.h. zunächst erfolgt eine Kühlung des Festkörperaktors an seiner Außenseite, bevor das Kühlmittel durch den wenigstens einen innenliegenden Hohlkanal geführt und anschließend abgeführt wird.

Je nach konstruktiver Ausgestaltung des Stellantriebes sowie auch in Abhängigkeit von dessen Verwendungs- und Einsatzzweck können zwischen gasförmigen und flüssigen Kühlmitteln geeignet gewählt werden. In einer vorteilhaften Ausgestaltung des lösungsgemäßen Kühlkonzeptes für in Stellantrieben integrierten Festkörperaktoren wird das von dem Festkörperaktor abgeleitete Kühlmedium, das auf aufgrund der thermischen Ankopplung durch den Wärmeentzug vom Festkörperaktor selbst eine Erwärmung erfährt, einem externen, d.h. räumlich getrennt vom Stellantrieb, Kühlprozess unterzogen und nach entsprechender Abkühlung erneut im Rahmen eines geschlossenen Kreislaufes dem Festkörperaktor erneut zugeführt. Auf diese Weise wird ein Verlust an Kühlmittel vermieden.

Das lösungsgemäße Kühlkonzept ist für sämtliche Festkörperaktoren innerhalb eines Stellantriebes anwendbar, so vorzugsweise für aus piezoelektrischen oder magnetostriktiven Material gefertigte Festkörperaktoren. Für die Erläuterung des lösungsgemäßen Kühlkonzeptes sei im Weiteren auf einen mit einem piezoelektrischen Aktor ausgestatteten Stellantrieb verwiesen, der jedoch nicht einschränkend für das allgemeine Lösungskonzept zur Kühlung eines in einem Stellantrieb integrierten Festkörperaktors zu sehen ist.

### Kurze Beschreibung der Erfindung

Die Erfindung wird nachstehend ohne Beschränkung des allgemeinen Erfindungsgedankens anhand eines Ausführungsbeispiels unter Bezugnahme auf die Zeichnung exemplarisch beschrieben. Es zeigt:
- Fig. 1: Längsschnitt durch einen Stellantrieb mit lösungsgemäßem Kühlkonzept,
- Fig. 2 a, b: Längs- und Querschnitt durch ein Verbindungsstück zum Verbinden zweier Aktorelemente innerhalb des Stellantriebes,
- Fig. 3 a-d: Querschnittdarstellungen von weiteren Varianten zur Ausbildung von Verbindungsstücken und
- Fig. 4: Längsschnitt durch einen stark schematisierten Stellantrieb mit vier axial in Serie geschalteten, hohlzylinderförmigen Aktorelementen

### Wege zur Ausführung der Erfindung, gewerbliche Verwendbarkeit

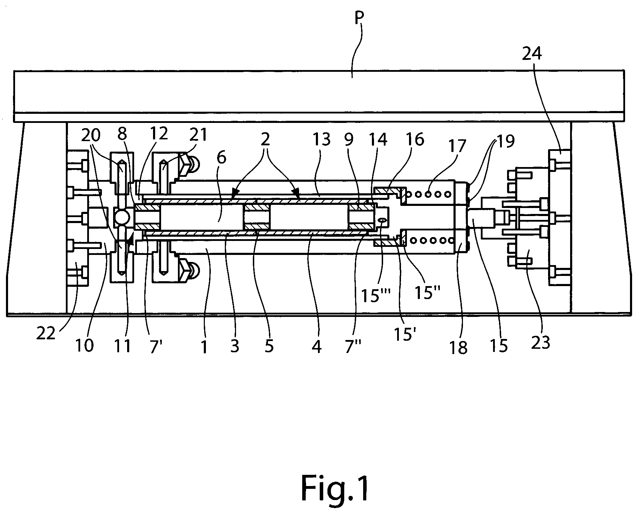

Figur 1 zeigt einen lösungsgemäß ausgebildeten Stellantrieb im Längsschnitt, der innerhalb eines Gehäuses 1 einen aus piezoelektrischem Material bestehenden Festkörperaktor 2 vorsieht, der im illustrierten Ausführungsbeispiel aus zwei hohlzylinderartig piezoelektrischen Festkörperelementen 3, 4 zusammengesetzt ist. Die hohlzylinderförmig ausgebildeten piezoelektrischen Festkörperelemente 3, 4 sind über ein vorzugsweise aus Kunststoff bestehendes, hülsenartig ausgebildetes Verbindungsteil 5 zu einem einheitlichen hohlzylinderartig ausgebildeten Körper gefügt, der einen inneren Hohlkanal 6 umschließt.

Die einzelnen piezoelektrischen Festkörperelementen 3, 4 sind jeweils aus einem monolithischen, piezoelektrischen Material zu einem Hohlzylinder geformt, an dessen beiden Hohlzylinderstirnseiten Elektroden angebracht sind, über die eine elektrische Spannung zur kontrollierten Längenausdehnung der piezoelektrischen Festkörperelemente 3, 4 applizierbar ist. Alternativ ist es gleichfalls möglich, die einzelnen hohlzylinderförmig ausgebildeten piezoelektrischen Elemente 3, 4 aus einer Vielzahl Schicht- oder lochscheiben-artig ausgebildeter Piezoelemente zu jeweils einem Aktorstapel zusammen zu setzen, wobei die einzelnen schicht- oder scheibenförmigen Piezoelemente jeweils aufeinander abgestimmt über eine kammartig ausgebildete Elektrodenstruktur mit elektrischer Spannung zur Aktoraktivierung beaufschlagt werden.

Durch die serielle, koaxiale Kopplung der beiden einzelnen piezoelektrischen Elemente 3, 4 zu einem als Hohlzylinder in Erscheinung tretenden Festkörperaktor 2 gelangen die Stellwegänderungen beider einzelnen piezoelektrischen Elemente 3, 4 bei geeigneter elektrischer Ansteuerung in additive Überlagerung. Selbstverständlich ist es möglich weitere hohlzylinderartig ausgebildete piezoelektrische Elemente über geeignet ausgebildete Zwischenstücke 5 miteinander zu kombinieren, um auf diese Weise die Gesamtstellwegänderung des Festkörperaktors 2 zu vergrößern.

Das zur Verbindung jeweils zweier piezoelektrischer Elemente 3, 4 dienende Verbindungsstück 5 ist als zylinder- bzw. hülsenartiges Kunststoffbauteil ausgebildet und verfügt über einen äußeren Hülsendurchmesser, der dem Innendurchmesser der jeweils hohlzylinderförmig ausgebildeten piezoelektrischen Elemente 3, 4 entspricht. Zur Verbindung beider hohlzylinderförmig ausgebildeten piezoelektrischen Elemente 3, 4 stoßen beide Elemente bündig an jeweils an ihren Stirnseiten unmittelbar zusammen, wobei beide piezoelektrischen Elemente 3, 4 zur dauerhaften Fügung innwandig mit dem hülsenartigen Verbindungsstück 5 mittels eines Adhäsivklebstoffes verbunden werden. Auf diese Weise ist sichergestellt, dass die zwischen beiden piezoelektrischen Elementen 3, 4 axial wirkenden Stellkräfte, die von den kontrolliert ansteuerbaren Längenveränderungen beider piezoelektrischen Elementen 3, 4 herrühren, verlustfrei von einem auf das andere Element übertragen werden.

Der auf die vorstehende Weise aus zwei einzelnen piezoelektrischen, hohlzylinderförmig ausgebildeten Elementen 3, 4 zusammengesetzte Festkörperaktor 2 verfügt somit über ein erstes stirnseitiges Ende 7' sowie ein diesem gegenüberliegendes zweites stirnseitiges Ende 7". Beide stirnseitigen Enden 7', 7" des Festkörperaktors 2 sind ebenfalls mit einem hülsenartig ausgebildeten Element 8, 9 verbunden, die innwandig an der Hohlzylinderinnenwand des Festkörperaktors 2 festsitzend verklebt sind und den Festkörperaktor 2 nach außen überragen. Die die Stirnseiten 7', 7" des Festkörperaktors 2 überragenden Bereiche der hülsenartigen Elemente 8, 9 dienen, wie der weiteren Beschreibung zu entnehmen ist, zur exakten Zentrierung des Festkörperaktor 2 innerhalb des Gehäuses 1. So mündet der die erste Stirnseite 7' des Festkörperaktors 2 überragende Bereich des hülsenartigen Elementes 8 passgenau und fluiddicht in eine in einem Ventilblock 10 eingebrachte Öffnung 11 ein, über die der Festkörperaktor 2 relativ zum Ventilblock 10 fest gefügt ist. Der Ventilblock 10 seinerseits mündet mit einem an den Innenquerschnitt des Gehäuses 1 angepassten Fortsatz 12 in das stirnseitige Ende des hohlzylinderförmig ausgebildeten Gehäuses 1 und verbindet dieses mit dem Ventilblock 10 fluiddicht.

Die Dimensionierungen des Außendurchmessers des zylinderförmig ausgebildeten Festkörperaktors 2 sowie der Innendurchmesser des den Festkörperaktor 2 umgebenden, hohlzylinderförmig ausgebildeten Gehäuses 1 sind derart aufeinander abgestimmt, so dass zwischen der Innenwand des Gehäuses 1 sowie der zylinderförmigen Außenmantelfläche des Festkörperaktors 2 ein Zwischenraum 13 eingeschlossen ist. Der Zwischenraum 13 erstreckt sich über die gesamte Länge des Festkörperaktors 2, der innerhalb des Gehäuses 1 an seiner zweiten Stirnseite 7" gleichsam zentriert gelagert ist. Hierzu mündet der die zweite Stirnseite 7" überragende Bereich des hülsenartigen Elementes 9 in eine entsprechende stufenförmige Ausnehmung 14 eines axial beweglich gelagerten Stellgliedes 15 ein. Das Stellglied 15 ist seinerseits relativ zum Gehäuse 1 über ein zentrierendes Mittel 16 zentriert, an dessen radial nach innen gewandten Gleitfläche, das Stellglied 15 mit einem ringförmigen Fortsatz 15' in axialem Gleitkontakt steht. Die radiale Außenseite des zentrierenden Mittels 16 ist über eine Presssitzpassung gegen die Innenkontur des Gehäuses 1 fest gefügt, so dass die Verbindung zwischen dem zentrierenden Mittel 16 und dem Gehäuse 1 fluiddicht abschließt. In gleicher Weise stellt der Gleitkontakt zwischen dem ringförmigen Fortsatz 15' des Stellgliedes 15 und der Innenwand des zentrierendes Mittels 16 eine fluiddichte Fügung dar.

Zum Zwecke einer auf den Festkörperaktor 2 einwirkenden mechanischen Vorspannung, die für die Aktorfunktion insbesondere für den Vorgang der Aktorkompression nach einer erfolgten Aktorlängung erforderlich ist, ist ein Federelement 17 vorgesehen, das den über das Gehäuse 1 hinausragenden Teil des Stellgliedes 15 bereichsweise radial umfasst und axial einseitig an einer Abstützplatte 18 angrenzt, die über vorzugsweise als Schraubverbindungen ausgebildete Befestigungsmittel 19 entgegen der Federkraft des Federelementes 17 mit der in der Darstellung entnehmbaren rechten Stirnseite des Gehäuses 1 verbunden ist. Das Federelement 17 stützt sich mit seiner der Abstützplatte 18 gegenüberliegenden Federseite unmittelbar an einem ringförmigen Absatz 15" am Stellglied 15 ab und treibt somit das Stellglied 15 federkraftbeaufschlagt axial entgegen des innerhalb des Gehäuses 1 zentriert gelagerten Festkörperaktors 2.

Wird der Festkörperaktor 2 durch entsprechende Beaufschlagung mittels einer elektrischen Spannung aktiviert, so dehnt sich der Festkörperaktor 2 entgegen der Federkraft des Federelementes 17 aus und bewegt das Stellglied 15 in axialer Richtung, d. h. bei Längenausdehnung des Festkörperaktors 2 wird das Stellglied 15 in der dargestellten Figur nach rechts ausgelenkt; im elektrisch spannungsfreien Fall bewirkt das Federelement 17 für eine beschleunigte Längenreduktion des Festkörperaktors 2. Ein derartiger Stellantrieb vermag hochdynamische Aktorauslenkungen zu realisieren, wie sie insbesondere zu Prüfzwecken an Proben zum Einsatz gelangen. Derartige hochdynamische Prozesse bewirken jedoch eine starke Erwärmung des Festkörperaktors 2, den es mit Hilfe der lösungsgemäß illustrierten Konstruktion effektiv zu kühlen gilt.

Zu Zwecken der aktiven Festkörperaktorkühlung ist im Ventilblock 10 eine erste Hohlleitung 20 vorgesehen, die fluiddicht mit dem den Festkörperaktor 2 vollständig durchsetzenden Hohlkanal 6 verbunden ist. Im dargestellten Ausführungsbeispiel sind zwei Leitungszuführungen 20 innerhalb des Ventilblockes 10 eingebracht, die über das hülsenartige Element 8 in den Hohlkanal 6 des Festkörperaktors 2 münden.

Der Hohlkanal 6 ist im Bereich seiner zweiten Stirnseite 7" fluidisch mit dem Zwischenraum 13, den der Festkörperaktor 2 und das Gehäuse 1 jeweils radial begrenzen, verbunden. Hierzu ist im Bereich des Stellgliedes 15 wenigstens eine radial angebrachte Durchtrittsöffnung 15"' vorgesehen, die innerhalb einer sacklochartig ausgebildeten Ausnehmung innerhalb des Stellgliedes 15 angeordnet ist. Die sacklochartig ausgebildete Ausnehmung innerhalb des Stellgliedes 15 ist mit dem Hohlkanal 6 über das hülsenartig ausgebildete Element 9 fluiddicht verbunden. Der Zwischenraum 13 ist schließlich mit einer das Gehäuse 1 im Bereich der ersten Stirnseite 6 des Festkörperaktors 2 mit wenigstens einer zweiten Hohlleitung 21 verbunden.

Zu Kühlzwecken des Aktors wird flüssiges oder gasförmiges Kühlmittel durch die erste Hohlleitung 20 in den Hohlkanal 6 des Festkörperaktors 2 geführt, so dass das Kühlmittel im dargestellten Fall von links nach rechts durch den Hohlkanal 6 strömt. Über die Verbindungsöffnung 15'" gelangt das Kühlmittel in den Zwischenraum 13, in dem es mit umgekehrter Durchströmungsrichtung, d. h. im dargestellten Fall von rechts nach links die Manteloberfläche des Festkörperaktors 2 überströmt und dadurch zu kühlen vermag. Letztlich tritt das Kühlmittel über den zweiten Hohlkanal 21 nach außen aus.

Selbstverständlich ist es möglich das Kühlmittel auch in der umgekehrten Durchströmungsrichtung zu Kühlzwecken durch den Stellantrieb zu führen, d. h. der Kühlmitteleinlass erfolgt über die zweite Hohlleitung 21, so dass das Kühlmittel zunächst durch den Zwischenraum 13 strömt und somit die Außenseite des Festkörperaktors 2 zu kühlen vermag. Anschließend gelangt das Kühlmittel durch die wenigstens eine Verbindungsöffnung 15"' in den Hohlkanal 6 des Festkörperaktors 2 und tritt schließlich über die erste Hohlleitung 20 nach außen.

Für einen geeigneten Leitungsdruck, mit dem das Kühlmittel durch die entsprechenden Hohlleitungen innerhalb des Stellantriebes getrieben wird, sorgt eine nicht weiter dargestellte Förderpumpe, die mit einem ebenso nicht dargestellten Kühlmittelreservoir verbunden ist.

Um einen unnötigen Kühlmittelverlust zu vermeiden, bietet es sich an, das Kühlmittel nach Austritt aus dem Stellantrieb zu kühlen, d. h. einer entsprechenden Kühleinheit zuzuführen, die in einem geschlossenen Kreislauf mit einem Kühlmittelreservoir verbunden ist, aus dem die Zuleitung von Kühlmittel in den Stellantrieb sichergestellt wird.

Der illustrierte Stellantrieb ist in einem Prüfrahmen P montiert. Hierzu ist der Stellantrieb über den Ventilblock 10 an einer entsprechend ausgebildeten Befestigungsplatte 22 am Prüfrahmen P fest angebracht. Der aus dem Stellantrieb überragende Bereich des Stellgliedes 15 mündet axial geführt in eine Kraftmessdose 23, die ihrerseits gleichfalls über eine Befestigungsplatte 24 am Prüfrahmen P befestigt ist.

Wie bereits erwähnt, ist es bei seriell-koaxialer Kopplung zweier piezoelektrischer Elemente 3, 4 zu einem einheitlichen, als Hohlzylinder in Erscheinung tretenden länglichen Festkörperaktor 2 hilfreich und erforderlich beide Elemente 3, 4 im Bereich ihrer jeweils stirnseitig einander zugewandten Enden mit einem zylinder- bzw. hülsenartigen Verbindungsstück fest aneinander zu fügen. Dabei gelangen die stirnseitigen Enden beider piezoelektrischen Elemente 3, 4 in unmittelbaren Kontakt, während den Stirnseiten nahe liegende Innenwandbereiche beider Elemente 3, 4 über das hülsenartige Verbindungsstück mittels Adhäsionskleber fest zusammengefügt sind.

Im Bestreben den gesamtheitlichen Festkörperaktor 2 zu vergrößern, um auf diese Weise größere Stellwege und/oder größere Stellkräfte generieren zu können, bietet es sich an mehr als zwei hohlzylinderartig ausgebildete Einzelaktoren, sei es in Form piezoelektrischer oder magnetostriktiver hohlzylindrischer Elemente oder Aktorstapel, die jeweils aus einer Vielzahl von schicht- oder lochscheibenartig ausgebildeten piezo- oder magnetostriktiven Einzelkomponenten zusammengesetzt sind, zu kombinieren. Dies jedoch setzt ein Verbindungsstück voraus, das für eine optimierte gegenseitige stabile Abstützung sowie auch für eine exakte Zentrierung der axial gefügten Aktorelemente relativ zueinander sowie auch gegenüber dem den gesamten Festkörperaktor umgebenden Gehäuse sorgt.

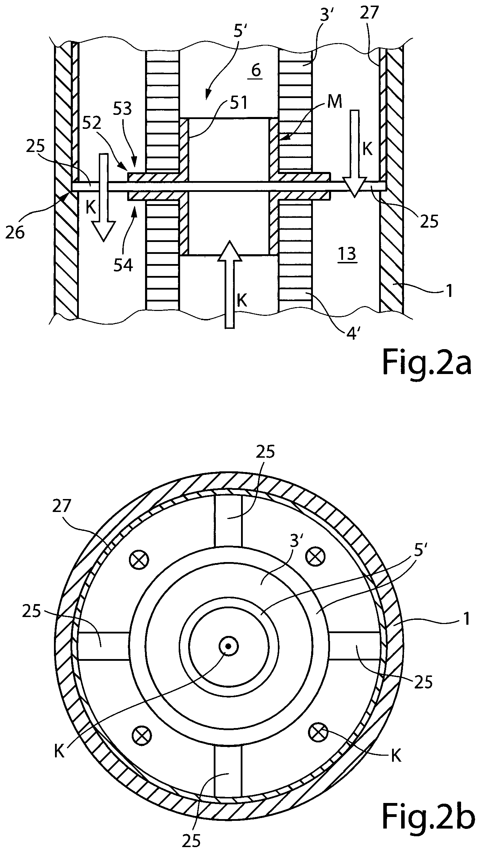

Eine bevorzugte Ausführungsform zur Ausbildung eines derartigen Verbindungsstückes 5' ist in Figur 2a in Form eines Längsschnittes sowie in Figur 2b als Querschnittsdarstellung durch einen Stellantrieb illustriert. Das Verbindungsstück 5' besteht im Wesentlichen aus einem zylinder- bzw. hülsenförmig ausgebildeten Grundkörper 51, dessen äußerer Hülsendurchmesser jeweils dem Innendurchmesser der hohlzylinderförmigen Aktorelemente 3', 4' entspricht. Im dargestellten Fallbeispiel ist angenommen, dass die hohlzylinderförmig ausgebildeten Aktorelemente 3', 4' über gleiche Geometrien verfügen, so dass der hohlzylinderförmig ausgebildete Grundkörper 51 über einen einheitlichen äußeren Hülsendurchmesser verfügt. Selbstverständlich sind Ausgestaltungsformen des hohlzylinderförmigen Grundkörpers 51 denkbar, bei denen der Außendurchmesser individuell an die Innendurchmesser unterschiedlich dimensionierter, hohlzylinderförmig ausgebildeter Aktorelemente 3', 4' angepasst ist.

Zur axialen Abstützung der Stirnseiten der beiden hohlzylinderförmig ausgebildeten Aktorelemente 3', 4' sieht das Verbindungsstück 5' einen den hohlzylinderförmigen Grundkörper umgebenden Hülsenkragen 52 vor, der zwei orthogonal zur Mantelfläche M des hohlzylinderförmigen Grundkörpers 51 orientierte, gegenseitig axial einander abgewandte Abstützflächen 53, 54 besitzt, an denen sich die hohlzylinderförmig ausgebildeten Aktorelemente 3', 4' unmittelbar stirnseitig abstützen. Der Hülsenkragen 52 umläuft die Mantelfläche M des hohlzylinderförmigen Grundkörpers 51 vollständig, so dass die Stirnseiten der Aktorelemente 3', 4' vollflächig jeweils an den Stirnseiten 53, 54 aufliegen.

In bevorzugter Weise sind die hohlzylinderförmigen Aktorelemente 3', 4' lose, d. h. ohne Adhäsivkleber mit dem Verbindungsstück 5' gefügt. Auf diese Weise werden etwaige Längenausdehnungseffekte längs der hohlzylinderförmigen Aktorelemente 3', 4' durch eine stofflich feste Verbindung mit der Mantelfläche M des Verbindungsstückes 5' nicht behindert.

Die Dimensionierung und Anordnung des Verbindungsstückes 5' wird zwischen dem jeweils axial gefügten hohlzylinderförmigen Aktorelementen 3', 4' derart gewählt, dass der Kühlmittelfluss K , wie er in Verbindung mit dem Ausführungsbeispiel gemäß Figur 1 erläutert worden ist, nicht oder nur unwesentlich beeinflusst wird. Der Hülsenkragen 52 ist jeweils radial beabstandet zum Gehäuse 1 angeordnet, so dass der Kühlmittelfluss K, der im gezeigten Beispiel in Figur 2a längs des Hohlkanals 6 von unten nach oben sowie innerhalb des Zwischenraumes 13 von oben nach unten gerichtet ist, unbeeinflusst bleibt.

Zu Zwecken einer Zentrierung der hohlzylinderförmig ausgebildeten Aktorelemente 3', 4' innerhalb des Gehäuses 1 dienen Zentriermittel 25, die vorzugsweise in Form von stift- oder stegartigen Federelementen ausgebildet sind und jeweils in Form eines zweiseitig eingespannten Federbalkens, einerseits mit dessen radial nach innen orientierten Ende mit dem Verbindungsstück 5' und mit dem radial nach außen gewandten Ende mit dem Gehäuse 1 gefügt sind. Zu Zwecken einer definierten axialen Fixierung der Zentrierelemente 25 sieht das Gehäuse 1 an seiner Innenseite einen mechanischen Anschlag 26 vor, an dem jeweils das radial äußere Ende der Zentrierelemente 25 aufliegt. Zur axialen Sicherung sowie Fixierung der Zentrierelemente 25 dient eine Fixierhülse 27, die innwandig in das Gehäuse 1 eingebracht ist.

Die Zentrierelemente 25, die gemäß Querschnittsdarstellung in Figur 2b die Verbindungshülse 5' an vier lokalen Stellen zentrisch zum Gehäuse 1 fixieren, vermögen sich bei Längenänderung der hohlzylinderförmig ausgebildeten Aktorelemente 3', 4' in Axialrichtung zu verformen, so dass gewährleistet ist, dass die Zentrierelemente 25 die Längenänderung der Aktorelemente 3', 4' nicht zu behindern vermögen. Selbstverständlich können weniger oder mehr als vier Zentrierelemente 25 zu Zwecken der Zentrierung der Verbindungshülse 5' innerhalb des Gehäuses, möglichst gleich verteilt in Umfangsrichtung um das hülsenförmig ausgebildete Verbindungsstück 5' vorgesehen werden. Um die axiale Lageänderung der Aktorelemente 3', 4' nicht zu behindern, ist es besonders vorteilhaft, die radial nach innen gewandten Enden der Zentrierelemente radial gleitend in dem Verbindungsstück 5' zu lagern.

Mit Hilfe des vorgeschlagenen Verbindungsstückes 5' können Stellantriebe realisiert werden, deren Festkörperaktor sich aus zwei aber insbesondere aus drei und mehreren, einzelnen hohlzylinderförmig ausgebildeten Aktorelementen zusammensetzt. Die Verbindungsstücke sichern sowohl den axialen Zusammenschluss jeweils zweier Aktorelemente, aber helfen insbesondere eine radial gerichtete Verkippung oder Lageänderung zu vermeiden, vor allem bei Festkörperaktoren, die sich aus vielen axial gekoppelten Aktorelementen zusammensetzen und so eine beträchtliche Gesamtaktorlänge ergeben.

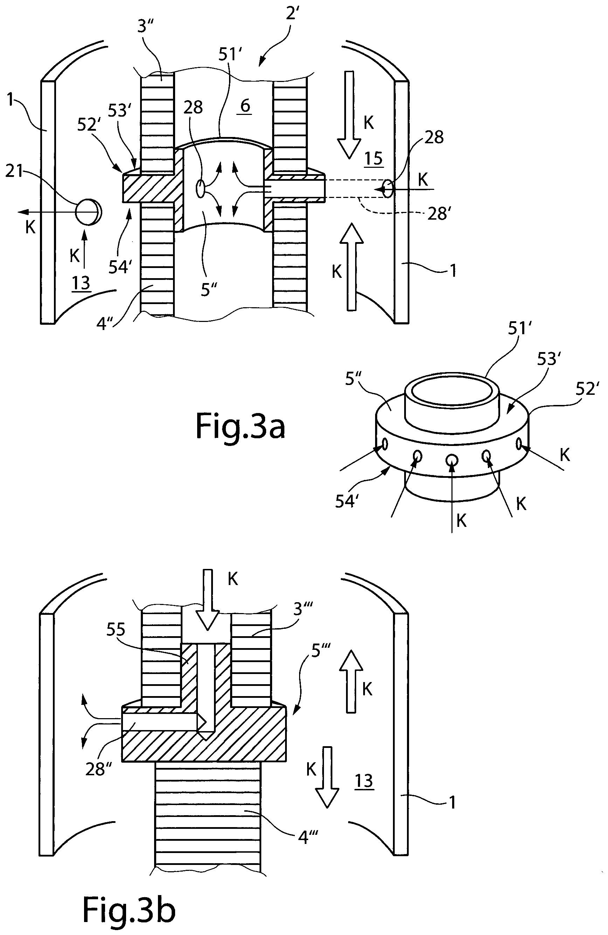

In Figur 3a ist ein weiteres Ausführungsbeispiel in Längsschnittdarstellung und als perspektivisches Einzelteil zur Realisierung eines Verbindungsstückes 5" dargestellt, das gleichsam zum Ausführungsbeispiel gemäß Figur 2a, b über einen hohlzylinderförmigen Grundkörper 51' verfügt, der einen Außendurchmesser besitzt, der den Innendurchmessern der ansonsten gleichförmig ausgebildeten hohlzylinderförmigen Aktorelementen 3", 4" entspricht. Das hohlzylinderförmige ausgebildete Verbindungsstück 5" weist ebenfalls einen Hülsenkragen 52' auf, der den hohlzylinderförmigen Grundkörper 51' des Verbindungsstückes 5" ringartig vollständig umfasst und zwei Abstützflächen 53', 54' aufweist, an denen sich die Stirnseiten beider Aktorelemente 3", 4" abstützen.

Zusätzlich ist im Hülsenkragen 52' eine Vielzahl radial orientierter Durchgangskanäle 28 eingebracht, durch die Kühlmittel vom inneren Hohlkanal 6 in den Zwischenraum 13 oder umgekehrt fließen kann. Das Gehäuse 1 ist nur andeutungsweise gezeigt.

Die Vielzahl von Durchgangskanälen 28 ist in azimuthaler Gleichverteilung innerhalb des Hülsenkragens 52' eingebracht, so dass ein möglichst symmetrischer Kühlmittelfluss bzw. Kühlmittelaustausch zwischen dem Hohlkanal 6 und dem Zwischenraum 13 durch das Verbindungsstück 5' hindurch erfolgen kann.

In Abwandlung zu der Kühlmittelzu- und abführung in den Hohlkanal 6, wie dies in Zusammenhang mit dem Ausführungsbeispiel gemäß Figur 1 beschrieben ist, bietet es sich in Anwendung des in Figur 3a illustrierten Verbindungsstückes 5' an, die Kühlmittelzuführung durch die innerhalb des Verbindungsstückes 5' radial orientierten Durchgangskanäle 28 vorzunehmen. Auf diese Weise bildet sich innerhalb des Hohlkanals 6 eine Aufteilung der Strömungsrichtung in zwei axial entgegengesetzte Strömungsrichtungen aus, wie dies in Figur 3a durch die Strömungspfeile illustriert ist. Zur Kühlmittelzuführung längs der Durchgangskanäle 28 bietet es sich bspw. an, Verbindungskanale 28' vorzusehen, die durch das Gehäuse 1 hindurchragen und von Außen eine Kühlmittelversorgung sicherstellen und mittel- oder unmittelbar mit den Durchgangskanälen fluidisch verbunden sind. Auf diese Weise stellt die Vielzahl der mit den Durchgangskanälen 28 verbundenen Verbindungskanäle 28' eine Zentrierung des Verbindungsstückes 5" innerhalb des Gehäuses 1 sicher.

Zur axialen Kühlmitteldurchströmung des radial an den durch die koaxiale Kombination von zwei oder mehreren hohlzylinderförmigen Aktorelementen 3", 4" zusammengesetzten Festkörperaktors 2 angrenzenden Zwischenraumes 13 gilt es an den axial sich gegenüberliegenden, nicht in Figur 3a dargestellten Enden des Festkörperaktors 2' Strömungsumlenkungen vorzusehen, durch die die jeweils axial innerhalb des Hohlkanals 6 geführten Kühlmittelströmungen K in den radial außen liegenden Zwischenraum 13 gelangen. Durch die Strömungsumlenkung an beiden sich axial gegenüberliegenden Enden des Festkörperaktors 2' bilden sich zwei axial aufeinander zu orientierte Kühlmittelströmungen aus, die im Bereich des Verbindungsstückes 5' zusammentreffen, wie dies aus den Strömungspfeilen gemäß Figur 3a zu entnehmen ist. Zur Abführung der konvergent zusammentreffenden Strömungsteile K gilt es im Gehäuse 1 über wenigstens eine das Kühlmittel K abführende Hohlleitung 21 vorzusehen, über die das erwärmte Kühlmittel einer entsprechenden Kühlung zugeführt werden kann.

In Figur 3b ist eine weitere Variante zur Ausbildung eines Verbindungsstückes 5'" illustriert, das nicht unter den Gegenstand der Ansprüche fällt. In diesem Fall sei angenommen, dass das untere Aktorelement 4'" als Vollzylinder ausgebildet ist, dessen obere Stirnseite an ein stempelförmig ausgebildetes Verbindungsstück 5'" unmittelbar anstößt. Das obere Aktorelement 3'" ist hohlzylinderförmig ausgebildet und weist einen hohlzylinderförmigen Innenraum auf, in den ein hohlzylinderförmig ausgebildeter Abschnitt 55 des ansonsten stempelförmig ausgebildeten Verbindungsstückes 5'" passgenau einmündet.

Der von dem hohlzylinderförmig ausgebildeten Abschnitt 55 umgebende Hohlraum ist fluidisch mit einer Vielzahl von radial orientierten Durchgangskanälen 28" verbunden, die radial frei in den Zwischenraum 13 einmünden. Ein mögliches Kühlmitteldurchströmungsszenario ist anhand der in Figur 3b illustrierten Kühlmittelströmungspfeile K zu entnehmen, wobei eine Kühlmittelzufuhr längs des Hohlkanals 6 erfolgt, so dass der Kühlmittelfluss nach Durchtritt durch die radial orientierten Durchgangskanäle 28" bidirektional sowohl axial nach oben als auch nach unten gerichtet durch den Zwischenraum 13 hindurchströmt. In diesem Fall gilt es zur Abführung von erwärmtem Kühlmittel an den jeweils axial gegenüberliegenden Enden des Festkörperaktors 2 entsprechende abführende Hohlkanäle vorzusehen.

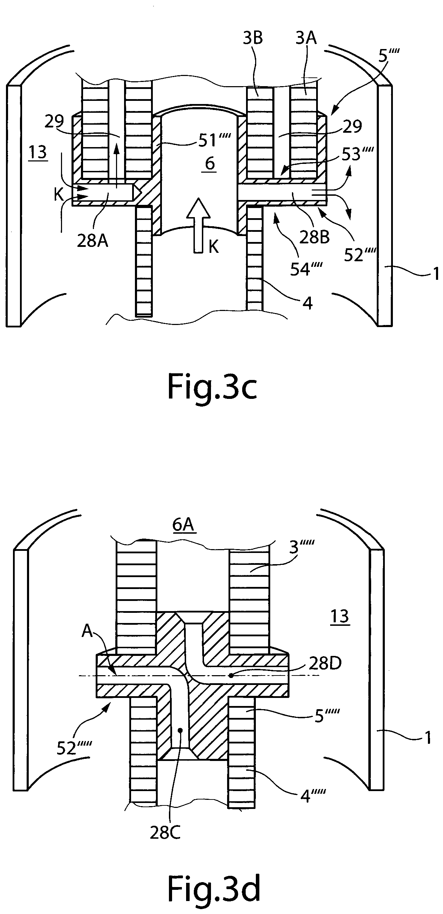

In Figur 3c ist eine Ausführungsform zur Realisierung eines Verbindungsstückes 5"" illustriert, mit der es möglich ist, wenigstens drei hohlzylinderförmig ausgebildete Aktorelemente miteinander zu kombinieren. So sind zwei hohlzylinderförmig ausgebildete Aktorelemente 3A, 3B koaxial ineinander angeordnet, wobei die Aktorelemente 3a, 3b derart dimensioniert ausgebildet sind, so dass das äußere hohlzylinderförmige Aktorelement 3A das innenliegende Aktorelement 3B mit einem radialen Zwischenspalt 29 umgibt. Beide Aktorelemente 3A, 3B vermögen aufgrund ihrer koaxialen Parallelanordnung die zu generierende gesamtheitlich Stellkraft zu vergrößern. Beide hohlzylinderförmig ausgebildete Aktorelemente 3A, 3B stützen sich gemeinsam auf eine obere Abstützfläche 53"" des Verbindungsstückes 5"" ab. An der unteren Abstützfläche 54"" grenzt stirnseitig ein hohlzylinderförmiges Aktorelement 4"" an. Das Verbindungsstück 5"" weist gleichsam wie im Falle der Figuren 2a, b bzw. 3a einen hohlzylinderförmig ausgebildeten Grundkörper 51"" auf, dessen Außendurchmesser an den Innendurchmesser der hohlzylinderförmigen Aktorelementen 3B sowie 4"" angepasst ist.

Zur Kühlung der Aktorelemente 3A, 3B sowie 4"" sind innerhalb des Hülsenkragens 52"" Durchgangskanäle eingebracht. Wenigstens ein erster Durchgangskanal 28A sorgt für eine fluidische Verbindung zwischen dem außen liegenden Zwischenraum 13 und dem radialen Zwischenspalt 29. Wenigstens ein zweiter Durchgangskanal 28b sorgt für einen Kühlmittelaustausch zwischen dem inneren Hohlkanal 6 und dem Zwischenraum 13.

Die in Figur 3c dargestellten Strömungspfeile geben die sich innerhalb des Hohlkanals 6, des Zwischenraums 13 sowie des radialen Zwischenspaltes 29 einstellende Kühlmittelströmung K wieder.

In Figur 3d ist ein weiteres Ausführungsbeispiel zur Realisierung der axialen Kombination zweier hohlzylinderförmig ausgebildeter Aktorelemente 3""' sowie 4""' angegeben, wobei sich beide Aktorelemente hinsichtlich ihrer Dicke der Hohlzylinderwand signifikant unterscheiden. Im dargestellten Fallbeispiel ist das obere hohlzylinderförmig ausgebildete Aktorelement 3""' in der Wandstärke größer ausgebildet als das untere Aktorelement 4""'. Das zwischen beiden Aktorelementen angeordnete Verbindungsstück 5""' weist in diesem Fall keinen hohlzylinderförmig ausgebildeten Grundkörper auf, vielmehr ist das Verbindungsstück 5""' in Form eines Verbindungspfropfens ausgebildet, dessen äußere Kontur sich an die Innendurchmesser der jeweiligen hohlzylinderförmig ausgebildeten Aktorelemente 3""' bzw. 4""' fluiddicht anschmiegt. Das Verbindungsstück 5""' verfügt über Durchgangskanäle 28C, 28D, die derart dimensioniert und angeordnet sind, so dass der erste Durchgangskanal 28C eine fluidische Verbindung zwischen dem Hohlkanal 6B, der von dem unteren Aktorelement 4""' begrenzt wird, mit dem Zwischenraum 13 herstellt, wohingegen der zweite Durchgangskanal 28D den Hohlkanalabschnitt 6A der vom oberen hohlzylinderförmig ausgebildeten Aktorelement 3""' begrenzt wird, mit dem radial außen liegenden Zwischenraum 13 verbindet. Beide Durchgangskanäle 28B, 28C münden jeweils in einer einheitlichen axialen Austrittsebene A, die den Hülsenkragen 52""' durchsetzt.

Sämtliche in den Figuren 1 bis 3 illustrierten Verbindungsstücke dienen einer sicheren axialen Kombination jeweils von zwei hohlzylinderförmig ausgebildeter Aktorelemente, oder wie im Fall der Figur 3b einem vollzylinderförmig ausgebildeten Aktorelement mit einem hohlzylinderförmig ausgebildeten Aktorelement. Selbstverständlich ist es möglich sämtliche illustrierten Verbindungsstücke für die axiale Kombination einer beliebigen Anzahl einzelner hohlzylinderförmig ausgebildeter Aktorelemente zur Ausbildung eines großen, länglich ausgebildeten Festkörperaktors in beliebiger Kombination miteinander einzusetzen.

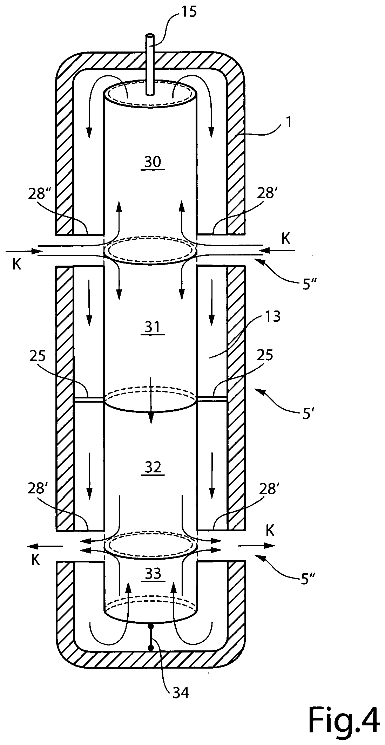

Fig. 4 illustriert eine von vielen Möglichkeiten zur Ausbildung eines Stellantriebes mit mehr als zwei koaxial kombinierten, einzelnen hohlzylinderförmig ausgebildeten Aktorelementen. Der stark schematisiert in Fig. 4 dargestellte Stellantrieb 1 weist innerhalb sein es Gehäuses 1 vier axial in Serie kombinierte hohlzylinderförmig ausgebildete Einzelaktoren 30, 31, 32, 33 auf, die in ihrer gesamten seriellen Anordnung den Festkörperaktor bilden, der sich mit seinem unteren Ende an einem mechanisch festen Gegenlager 34 am Gehäuse 1 einseitig abstützt und dessen oberes Ende das Stellglied 15 aufweist, das durch das Gehäuse 1 hindurch ragt. Die Fig. 4 soll insbesondere verdeutlichen, dass mehrere unterschiedliche Verbindungsstücke 5", 5', 5" für den Aufbau eines Festkörperaktors 2 einsetzbar sind. So werden die hohlzylinderförmigen Aktorelemente 30 und 31 sowie 32 und 33 jeweils über ein Verbindungsstück 5" axial gefügt, das in Fig. 3a illustriert ist. Das betreffende Verbindungsstück 5" verfügt über radial orientierte Durchgangskanäle 28', die im illustrierten Ausführungsbeispiel gemäß Fig. 4 fluiddicht mit der Gehäusewand 1 verbunden sind und auf diese Weise einen radialen Zu- bzw. Abfluss eines Kühlmittels K von außen in das Innere des Festkörperaktors 2 oder umgekehrt ermöglichen. Die Verbindungskanäle 28' des Verbindungsstückes 5", das die hohlzylinderförmig ausgebildeten Aktorelemente 32 und 33 koaxial miteinander verbinden, dienen im angegebenen Fallbeispiel als Ausflusskanäle, durch die jeweils Kühlmittel vom inneren Hohlraum 6 nach außen abfließen kann, wo es einer Kühleinrichtung (nicht dargestellt) zugeführt wird, von der das Kühlmittel K wieder erneut durch die Durchgangskanäle 28' des die Aktorelemente 30 und 31 verbindenden Verbindungsstückes 5" zur Zuführung in den Festkörperaktor im Kreislauf zugeführt werden kann.

Um die axiale Festkörperlängsausdehnung nicht einzuschränken, gilt es dafür Sorge zu tragen, die Durchgangskanäle 28' jeweils möglichst flexibel zu gestalten, so dass sich der Festkörperaktor 2 in dessen Längsrichtung ungehindert ausdehnen kann.

Zur koaxialen Verbindung der hohlzylinderförmig ausgebildeten Aktorelemente 31, 32 dient das in den Fig. 2a und b illustrierte Verbindungsstück 5', dessen radial orientierte Zentrierelemente 25 den Festkörperaktor 2 zentrisch und koaxial innerhalb des Gehäuses 1 zu zentrieren vermögen.

Selbstverständlich können beliebig weitere Kombinationen der vorstehend illustrierten, insbesondere unter Bezugnahme auf die Fig. 3a bis d skizzierten Verbindungsstücke für den Aufbau eines lösungsgemäß ausgebildeten Stellantriebes mit einem Festkörperaktor großer Aktorlängen eingesetzt werden.

### Bezugszeichenliste

- 1: Gehäuse
- 2: Festkörperaktor
- 3, 4: piezoelektrisches Element
- 3', 3", 3"', 3"",3"'": Hohlzylinderförmiges Aktorelement
- 4',4",4"",4""' 4'": Vollzylinderförmiges Aktorelement
- 5: hülsenartiges Element
- 51: hülsenartiger Grundkörper
- 52: Hülsenkragen
- 53: Abstützfläche
- 54: Abstützfläche
- 55: hohlzylinderförmig ausgebildeter Abschnitt
- 6: Hohlkanal
- 6A, 6B: Hohlkanalabschnitte
- 7',7": Erste, zweite Stirnseite des Festkörperaktors
- 8: hülsenartiges Element
- 9: hülsenartiges Element
- 10: Ventilblock
- 11: Ausnehmung
- 12: Fortsatz
- 13: Zwischenraum
- 14: Gestufte Ausnehmung

- 15: Stellglied
- 15': ringartiger Fortsatz
- 15": ringartige Anschlagfläche
- 15'": Verbindungsöffnung
- 16: zentrierendes Mittel
- 17: Federelement
- 18: Befestigungsplatte
- 19: Befestigungsmittel
- 20: erste Hohlleitung
- 21: zweite Hohlleitung
- 22: Befestigungsplatte
- 23: Kraftmessdose
- 24: Befestigungsplatte
- 25: Zentrierelement
- 26: Mechanischer Anschlag
- 27: Fixierhülse
- 28, 28A, 28B, 28C, 28D: Durchgangskanal
- 28': Verbindungskanal
- 29: Radialer Zwischenspalt
- 30-33: Hohlzylindrisches Aktorelement
- 34: Mechanischer Anschlag
- A: Austrittsebene
- P: Prüfrahmen

## Patentansprüche

1. Stellantrieb zum uniaxialen, bidirektionalen Auslenken eines Stellgliedes (15), das mittel- oder unmittelbar durch einen Festkörperaktor (2) betätigbar ist, der wenigstens ein sich mit einer ersten Stirnseite (7') mittel- oder unmittelbar in einem Gehäuse (1) abstützendes Festkörperaktorende aufweist, das bei Änderung einer am Festkörperaktor (2) anlegbaren elektrischen Spannung oder eines am Festkörperaktor wirkenden Magnetfeldes zumindest eine Längenänderung in einer dem Festkörperaktor (2) zuordenbaren Längserstreckung erfährt, die mittels einer der ersten Stirnseite (7') in Längserstreckung des Festkörperaktors (2) gegenüberliegenden zweiten Stirnseite (7") mittel- oder unmittelbar auf das Stellglied (15) zu dessen Lageverstellung übertragbar ist, wobei das Gehäuse (1) den Festkörperaktor (2) zumindest abschnittsweise umschließt und mit dem Festkörperaktor (2) wenigstens einen Zwischenraum (13) fluiddicht begrenzt und der
Festkörperaktor (2) einen den Festkörperaktor (2) zumindest bereichsweise durchsetzenden Hohlkanal (6) aufweist,
wobei der den Festkörperaktor (2) zumindest bereichsweise durchsetzende Hohlkanal (6) ein Hohlkanalende aufweist, das mit einer das Gehäuse (1) durchsetzenden ersten Hohlleitung (20) verbunden ist, wobei
der Hohlkanal ein
anderes Hohlkanalende aufweist, das in den wenigstens einen Zwischenraum (13) mündet, und
wobei der wenigstens eine Zwischenraum (13) fluiddicht mit einer das Gehäuse (1) durchsetzenden zweiten Hohlleitung (21) verbunden ist,
**dadurch gekennzeichnet, dass** der Festkörperaktor (2) wenigstens zwei hohlzylinderartig oder lochscheibenartig ausgebildete piezoelektrische oder magnetostriktive Elemente (3, 4) oder aus einer Vielzahl von hohlzylinder- oder lochscheibenartig ausgebildeten piezo- oder magnetostriktiven Einzelkomponenten zusammengesetzte Aktorstapel aufweist, die jeweils stirnseitig mittel- oder unmittelbar zusammengefügt sind,
dass zum Fügen der jeweils stirnseitig mittel- oder unmittelbar verbundenen piezoelektrischen oder magnetostriktiven Elemente oder Aktorstapel ein Verbindungsstück vorgesehen ist, und
dass das Verbindungsstück (5) zylinder- oder hülsenartig ausgebildet ist, mit einem äußeren Hülsendurchmesser, der dem Innendurchmesser der hohlzylinderförmigen Elemente oder Aktorstapel entspricht, die stirnseitig jeweils unmittelbar bündig zusammenstoßen und mit dem Verbindungsstück innwandig mittels eines Adhäsivklebers verbunden sind, oder
dass das Verbindungsstück zylinder- oder hülsenartig ausgebildet ist, mit einem äußeren Hülsendurchmesser, der dem Innendurchmesser der hohlzylinderförmigen Elemente oder Aktorstapel entspricht, und einem das zylinder- oder hülsenartig ausgebildete Verbindungsstück an seiner Mantelfläche (M) in Umfangsrichtung zumindest abschnittsweise radial überragenden Hülsenkragen (52), der jeweils zwei orthogonal zur Mantelfläche orientierte, gegenseitig axial einander abgewandte Abstützflächen (53, 54) besitzt, an denen die hohlzylinderförmigen Elemente oder Aktorstapel stirnseitig zumindest abschnittsweise anliegen.

2. Stellantrieb nach Anspruch 1,
**dadurch gekennzeichnet, dass** der Festkörperaktor (2) stabförmig ausgebildet ist und einen den Festkörperaktor (2) längs seiner Längserstreckung vollständig durchsetzenden Hohlkanal (6) aufweist, der beidseitig jeweils an den Stirnseiten (7', 7") des Festkörperaktors (2) mündet,
dass das Gehäuse (1) und der Festkörperaktor (2) den Zwischenraum (13) radial begrenzen, der den Festkörperaktor (2) in dessen gesamten Längserstreckung umschließt und im Bereich der zweiten Stirnseite (7") mit dem Hohlkanal (6) fluidisch verbunden ist, und
dass die zweite Hohlleitung (21) im Bereich der ersten Stirnseite (7') des Festkörperaktors (2) durch das Gehäuse (1) in den Zwischenraum (13) mündet.

3. Stellantrieb nach Anspruch 1 oder 2,
**dadurch gekennzeichnet, dass** der Festkörperaktor (2) ein piezoelektrischer Aktor ist, der die wenigstens zwei hohlzylinderartig oder lochscheibenartig ausgebildeten piezoelektrischen Elemente (3, 4) oder Aktorstapel vorsieht, die jeweils über getrennte elektrische Zuleitungen mit einer elektrischen Spannung versorgbar sind.

4. Stellantrieb nach Anspruch 1 oder 2,
**dadurch gekennzeichnet, dass** der Festkörperaktor (2) ein magnetostriktiver Aktor ist, der die wenigstens zwei hohlzylinderartig oder lochscheibenartig ausgebildeten magnetostriktiven Elemente oder Aktorstapel vorsieht, die jeweils stirnseitig mittel- oder unmittelbar zusammengefügt sind, eine Elektromagnetanordnung derart angeordnet und ausgebildet ist, dass deren veränderlich erzeugbares Magnetfeld in Wechselwirkung mit dem magnetostriktiven Aktor tritt.

5. Stellantrieb nach einem der Ansprüche 1 bis 4,
**dadurch gekennzeichnet, dass** im Bereich der zweiten Stirnseite (7") des Festkörperaktors (2) ein den Festkörperaktor (2) gegenüber dem Gehäuse (1) zentrierendes Mittel (16) vorgesehen ist, das sowohl mit dem Festkörperaktor (2) als auch mit dem bidirektional auslenkbaren Stellglied (15) in Wirkverbindung steht, das mit Hilfe eines Federelementes (17) den Festkörperaktor (2) axial vorspannt.

6. Stellantrieb nach einem der Ansprüche 1 bis 5,
**dadurch gekennzeichnet, dass** die erste Hohlleitung (20) mit einer Fluidpumpe verbunden ist, die ein aus einem Kühlmittelreservoir bevorratetes flüssiges oder gasförmiges Kühlmittel in den Hohlkanal (6) sowie den Zwischenraum (13) fördert, und dass die zweite Hohlleitung (21) mit einem Auslass verbunden ist.

7. Stellantrieb nach Anspruch 6,
**dadurch gekennzeichnet, dass** der Auslass mit einer das Kühlmittel abkühlenden Einheit fluiddicht verbunden ist, und
dass die das Kühlmittel abkühlende Einheit fluiddicht mit dem Kühlmittelreservoir verbunden ist.

8. Stellantrieb nach einem der Ansprüche 1 bis 7,
**dadurch gekennzeichnet, dass** der die Mantelfläche in Umfangsrichtung zumindest abschnittsweise radial überragende Hülsenkragen zum Gehäuse radial beabstandet ausgebildet und angeordnet ist.

9. Stellantrieb nach einem der Ansprüche 1 bis 8,
**dadurch gekennzeichnet, dass** an dem die Mantelfläche in Umfangsrichtung zumindest abschnittsweise radial überragenden Hülsenkragen wenigstens ein Zentrierelement (25) angebracht ist, das das Gehäuse berührt und den Festkörperaktor zentrisch innerhalb des Gehäuses abstützt.

10. Stellantrieb nach Anspruch 9,
**dadurch gekennzeichnet, dass** das wenigstens eine Zentrierelement stift- oder stegartig ausgebildet und in Art eines zweiseitig fest eingespannten Federbalkens sowohl mit dem Hülsenkragen als auch mit dem Gehäuse verbunden ist.

11. Stellantrieb nach einem der Ansprüche 1 bis 10,
**dadurch gekennzeichnet, dass** in dem die Mantelfläche in Umfangsrichtung zumindest abschnittsweise radial überragenden Hülsenkragen wenigstens ein Kanal (28) integriert ist, der eine fluidische Verbindung zwischen dem Hohlkanal und dem Zwischenraum schafft.

## Claims

1. Actuating drive for uniaxial, bi-directional deflection of an actuating element (15), which is operable indirectly or directly by a solid-state actuator (2) that has at least one solid-state actuator end which is supported with a first end face (7') indirectly or directly in a housing (1), which end undergoes at least a change of length in a lengthwise extension assignable to the solid-state actuator (2) when an electrical voltage that may be applied to the solid-state actuator (2) or a magnetic field acting on the solid-state actuator is changed, which can be transferred indirectly or directly to the actuating element (15) by means of a second end face (7") opposite the first end face (7') in the lengthwise extension of the solid-state actuator (2) to adjust the position thereof, wherein the housing (1) at surrounds at last a portion of the solid-state actuator (2) and together with the solid-state actuator (2) delimits an intermediate space (13) in fluid-tight manner, and the solid-state actuator (2) has a hollow channel (6) which passes through at least a region of the solid-state actuator (2), wherein the hollow channel (6) which passes through at least a region of the solid-state actuator (2) has a hollow channel end which is connected to a first hollow conduit (20) that passes through the housing (1), wherein the hollow channel has another hollow channel end which opens into the at least one intermediate space (13), and wherein the at least one intermediate space (13) is connected in fluid-tight manner to a hollow conduit (21) that passes through the housing (1),
**characterized in that** the solid-state actuator (2) has at least two piezoelectric or magnetorestrictive elements (3, 4) embodied as hollow cylinders or perforated discs or actuator stacks composed of a multiplicity of piezo- or magnetorestrictive single components embodied as hollow cylinders or perforated discs, which are joined indirectly or directly at the respective end faces thereof,
that a connecting member is provided to join the piezoelectric or magnetorestrictive elements or actuator stacks which are each connected indirectly or directly by the end faces thereof, and
that the connecting member (5) is constructed as a cylinder or sleeve, with an outer sleeve diameter that corresponds to the inner diameter of the hollow-cylindrical elements or actuator stacks, the end faces of each of which abut directly in flush manner, and which are attached to the connecting member at the inner wall via an adhesive bonding substance, or that the connecting member is embodied as a cylinder or a sleeve with an outer sleeve diameter that corresponds to the inner diameter of the hollow-cylindrical elements or actuator stacks, and with a sleeve collar (52) that extends circumferentially around the cylindrical or sleeve-like connecting member and protrudes radially beyond the outer surface (M) thereof at least in areas, which collar has two support faces (53, 54), which are each orientated orthogonally to the outer surface and face away from each other axially, on which at least a portion of the end faces of the hollow-cylindrical elements or actuator stacks are supported.

2. Actuating drive according to Claim 1, **characterized in that** the solid-state actuator (2) is rod-shaped and has a hollow channel (6) which passes completely through the solid-state actuator (2) along the lengthwise extension thereof, and which opens into the respective end faces (7', 7") on each side of the solid-state actuator (2),
that the housing (1) and the solid-state actuator (2) radially delimit the intermediate space (13), which surrounds the solid-state actuator (2) over the entire lengthwise extension thereof and is in fluid communication with the hollow channel (6) in the region of the second end face (7"), and
that the second hollow conduit (21) opens into the intermediate space (13) in the region of the first end face (7') of the solid-state actuator (2) through the housing (1).

3. Actuating drive according to Claim 1 or 2,
**characterized in that** the solid-state actuator (2) is a piezoelectric actuator which provides the at least two piezoelectric elements (3, 4) or actuator stacks embodied as hollow cylinders or perforated discs, which can each be supplied with an electrical voltage via separate electrical feed lines.

4. Actuating drive according to Claim 1 or 2,
**characterized in that** the solid-state actuator (2) is a magnetostrictive actuator which provides the at least two magnetostrictive elements or actuator stacks embodied as hollow cylinders or perforated discs, which are joined indirectly or directly at the respective end faces, that the variable magnetic field producible thereby enters into interaction with the magnetostrictive actuator.

5. Actuating drive according to any one of Claims 1 to 4,
**characterized in that** means (16) for centring the solid-state actuator (2) relative to the housing (1) is provided in the region of the second end face (7") of the solid-state actuator (2), which means is operatively connected to both the solid-state actuator (2) and the bi-directionally deflectable actuating element (15), and which biases the solid-state actuator (2) axially with the help of a spring element (17).

6. Actuating drive according to any one of Claims 1 to 5,
**characterized in that** the first hollow conduit (20) is connected to a fluid pump which delivers a stored liquid or gas-phase coolant from a coolant reservoir into the hollow channel (6) and the intermediate space (13), and that the second hollow conduit (21) is connnected to an outlet.

7. Actuating drive according to Claim 6,
**characterized in that** the outlet is connected in fluid-tight manner to a unit which cools the coolant, and
that the unit which cools the coolant is connected in fluid-tight manner to the coolant reservoir.

8. Actuating drive according to any one of Claims 1 to 7,
**characterized in that** the sleeve collar extending circumferentially around the outer surface which protrudes radially from it at least in a portion thereof is constructed and arranged with a radial separation from the housing.

9. Actuating drive according to any one of Claims 1 to 8,
**characterized in that** at least one centring element (25) is mounted on the sleeve collar extending circumferentially around the outer surface which protrudes radially from it at least in a portion thereof, which centring element touches the housing and supports the solid-state actuator centrally inside the housing.

10. Actuating drive according to Claim 9,
**characterized in that** the at least one centring element is constructed in the manner of a pin or a web and is connected both to the sleeve collar and to the housing in the manner of a cantilever which is fixed firmly on two sides.

11. Actuating drive according to any one of claims 1 to 10, **characterized in that** at least one channel (28) is integrated in the sleeve collar which extends circumferentially around the outer surface and protrudes radially from it at least in a portion thereof, which channel creates a fluidic connection between the hollow channel and the intermediate space.

## Revendications

1. Servomoteur pour la déviation uniaxiale, bidirectionnelle d'un organe de réglage (15), qui peut être fixé directement ou indirectement par l'intermédiaire d'un actionneur à corps solide (2), qui présente au moins une extrémité d'actionneur à corps solide s'appuyant directement ou indirectement dans un logement (1) avec un premier côté avant (7'), qui en cas de variation d'une tension électrique pouvant être appliquée sur l'actionneur à corps solide (2) ou d'un champ magnétique agissant sur l'actionneur à corps solide (2) subit au moins une variation de longueur dans une extension longitudinale pouvant être coordonnée à l'actionneur à corps solide (2), qui peut être transmise au moyen d'un deuxième côté avant (7") opposé au premier côté avant (7') dans l'extension longitudinale de l'actionneur à corps solide (2) directement ou indirectement à l'organe de réglage (15) à des fins de réglage de position de celui-ci, dans lequel le logement (1) englobe l'actionneur à corps solide (2) au moins par portions et délimite de manière étanche au fluide au moins un espace intermédiaire (13) avec l'actionneur à corps solide (2) et l'actionneur à corps solide (2) présente un canal creux (6) traversant au mois par portions l'actionneur à corps solide (2), dans lequel le canal creux (6) traversant au moins par portions l'actionneur à corps solide (2) présente une extrémité de canal creux, qui est relié à une première conduite creuse (20) traversant le logement (1), dans lequel le canal creux présente une autre extrémité de canal creux, qui débouche dans au moins un espace intermédiaire (13) et dans lequel au moins un espace intermédiaire (13) est relié de manière étanche au fluide avec une deuxième conduite creuse (21) traversant le logement (1), **caractérisé en ce que** l'actionneur à corps solide (2) présente au moins deux éléments (3,4) piézoélectriques ou magnétostrictifs réalisées en forme de cylindre creux ou en forme de disque perforé, ou une pile d'actionneur composée d'une pluralité de composants individuels piézostrictifs ou magnétostrictifs réalisés en forme de cylindre creux ou de disque perforé, qui sont respectivement assemblés directement ou indirectement du côté avant, **en ce que** pour l'assemblage des éléments piézoélectriques ou magnétostrictifs ou de la pile d'actionneur respectivement reliés directement ou indirectement du côté avant, une pièce de liaison est prévue et **en ce que** la pièce de liaison (5) est réalisée en forme de cylindre ou de manchon, avec un diamètre de manchon extérieur, qui correspond au diamètre intérieur des éléments en forme de cylindre creux ou de la pile d'actionneur, qui butent en affleurement respectivement directement du côté avant et sont reliés avec la pièce de liaison sur la paroi interne au moyen d'un adhésif ou **en ce que** la pièce de liaison est réalisée en forme de cylindre ou de manchon, avec un diamètre de manchon extérieur, qui correspond au diamètre intérieur des éléments en forme de cylindre creux ou de la pile d'actionneur, et à une collerette de manchon (52) dépassant en saillie radialement de la pièce de liaison réalisée en forme de cylindre ou de manchon au moins par portions sur sa surface de gaine (M) dans la direction circonférentielle, qui possède respectivement deux surfaces d'appui (53,54) orientées orthogonalement à la surface de gaine, se détournant mutuellement l'une de l'autre axialement, sur lesquelles les éléments en forme de cylindre creux ou la pile d'actionneur viennent reposer au moins par portions du côté avant.

2. Servomoteur selon la revendication 1, **caractérisé en ce que** l'actionneur à corps solide (2) est réalisé en forme de barre et présente un canal creux (6) traversant totalement l'actionneur à corps solide (2) longitudinalement à son extension longitudinale, qui débouche des deux côtés respectivement sur les côtés avant (7',7") de l'actionneur à corps solide (2), **en ce que** le logement (1) et l'actionneur à corps solide (2) délimitent radialement l'espace intermédiaire (13), qui englobe l'actionneur à corps solide (2) dans l'extension longitudinale totale de ce dernier et est relié fluidiquement avec le canal creux (6)au niveau du deuxième côté frontal (7"), et **en ce que** la deuxième conduite creuse (21) débouche dans l'espace intermédiaire (13) au niveau du premier côté avant (7') de l'actionneur à corps solide (2) à travers le logement (1).

3. Servomoteur selon la revendication 1 ou 2, **caractérisé en ce que** l'actionneur à corps solide (2) est un actionneur piézoélectrique, qui prévoit au moins deux éléments piézoélectriques (3,4) réalisés en forme de cylindre creux ou de disque perforé ou la pile d'actionneur, qui peuvent être alimentés respectivement avec une tension électrique par l'intermédiaire de lignes électriques séparées.

4. Servomoteur selon la revendication 1 ou 2, **caractérisé en ce que** l'actionneur à corps solide (2) est un actionneur magnétostrictif, qui prévoit au moins deux éléments magnétostrictifs réalisés en forme de cylindre creux ou de disque perforé ou une pile d'actionneur, qui sont respectivement assemblés directement ou indirectement du côté avant, un dispositif d'électroaimant est réalisé et disposé de telle sorte que son champ magnétique pouvant être généré de manière variable se trouve en interaction avec l'actionneur magnétostrictif.

5. Servomoteur selon une des revendications 1 à 4, **caractérisé en ce que** au niveau du deuxième côté frontal (7") de l'actionneur à corps solide (2), un moyen (16) centrant l'actionneur à corps solide (2) par rapport au logement (1) est prévu, qui est en liaison opérationnelle tant avec l'actionneur à corps solide (2) qu'avec l'organe de réglage (15) pouvant être dévié de manière bidirectionnelle, qui contraint axialement l'actionneur à corps solide (2) à l'aide d'un élément de ressort (17).

6. Servomoteur selon une des revendications 1 à 5, **caractérisé en ce que** la première conduite creuse (20) est relié avec une pompe de fluide, qui refoule un liquide réfrigérant gazeux ou liquide stocké dans un réservoir de liquide réfrigérant dans le canal creux (6) ainsi que dans l'espace intermédiaire (13) et **en ce que** la deuxième conduite creuse (21) est reliée à un échappement.

7. Servomoteur selon la revendication 6, **caractérisé en ce que** l'échappement est relié de manière étanche au fluide avec une unité refroidissant le liquide réfrigérant et **en ce que** l'unité refroidissant le liquide réfrigérant est reliée avec le réservoir de liquide réfrigérant.

8. Servomoteur selon une des revendications 1 à 7, **caractérisé en ce que** la collerette de manchon dépassant en saillie radialement au moins par portions de la surface de gaine dans la direction circonférentielle est réalisée et disposée de manière espacée radialement par rapport au logement.

9. Servomoteur selon une des revendications 1 à 8, **caractérisé en ce que** sur la collerette de manchon dépassant en saillie radialement au moins par portions de la surface de gaine dans la direction circonférentielle, au moins un élément de centrage (25) est monté, qui contacte le logement et appuie l'actionneur à corps solide de manière centrique à l'intérieur du logement.

10. Servomoteur selon la revendication 9, **caractérisé en ce que** au moins un élément de centrage est réalisé en forme de gradin ou de broche et est relié à la manière d'une poutre élastique encastrée solidement des deux côtés tant avec la collerette de manchon qu'avec le logement.

11. Servomoteur selon une des revendications 1 à 10, **caractérisé en ce que**, dans la collerette de manchon dépassant en saillie radialement au moins par portions de la surface de gaine dans la direction circonférentielle, au moins un canal (28) est intégré, qui établit une liaison fluidique entre le canal creux et l'espace intermédiaire.
